# EUROPEAN PATENT APPLICATION

(11) **EP 2 101 412 A1**
(43) Date of publication of application: **16.09.2009**
(21) Application number: 09163004.6
(22) Date of filing: 25.04.2008
(51) Int. Cl.: H03H 7/01, H01P 1/203, H01P 1/201, H05K 1/18, H01G 5/40

(54) **Variable filter element, variable filter module and fabrication method thereof**

(30) Priority: 27.04.2007 JP 2007118583
(62) Divisional of application: 08103724.4
(71) Applicant: Fujitsu Limited, Kawasaki-shi, Kanagawa 211-8588 (JP)
(72) Inventor: Mi, Xiaoyu, Kanagawa 211-8588 (JP); Shimanouchi, Takeaki, Kanagawa 211-8588 (JP); Imai, Masahiko, Kanagawa 211-8588 (JP); Ueda, Satoshi, Kanagawa 211-8588 (JP); Satoh, Yoshio, Kanagawa 211-8588 (JP)
(74) Representative: Stebbing, Timothy Charles

(57) **Abstract**

A variable filter element and a variable filter module suitable for decreasing the drive voltage are provided. The variable filter element includes a substrate, two ground lines and a signal line between the ground lines, where these lines are disposed to extend in parallel on the substrate. The filter element further includes movable capacitor electrodes which bridge between the ground lines and have portions facing the signal line, drive electrodes which are located between the signal line and the ground lines and generate electrostatic attraction with the movable capacitor electrodes, and a ground line, which is disposed in the substrate, has a portion facing the signal line, and is electrically connected with the ground. The variable capacitor electrodes and the ground line constitute ground interconnection portions, and the signal line and ground interconnection portion constitute a distributed constant transmission line.

## Description

### BACKGROUND OF THE INVENTION

### 1. Field of the Invention:

The present invention relates to a high frequency band variable filter element having a micro structure formed by micro machining technology, a module comprising such a variable filter element, and a fabrication method thereof.

### 2. Description of the Related Art:

Lately the application of elements having a micro structure formed by micro machining technology is being attempted in various technology fields. An example of such elements is a variable filter element which can change passing frequencies. A service to provide this element is becoming diversified and showing advanced functions as the mobile communication equipment market, such as portable telephones, expands, and along with this trend, frequencies used for the equipment is gradually shifting to the GHz level or higher frequencies and to multi-channels, therefore the development of variable filter elements is progressing to meet demands for higher frequencies and multi-channels. Such variable filter elements are disclosed in Japanese Patent Application Laid-Open No. 2003-332808; Japanese Patent Application Laid-Open No. 2006-128912; and A. A. Tamijani, et al: "Miniature and Tunable Filters Using MEMS Capacitors", IEEE Trans. Microwave Theory Tech., Vol. 51, No. 7, pp. 1878 - 1885, July 2003.

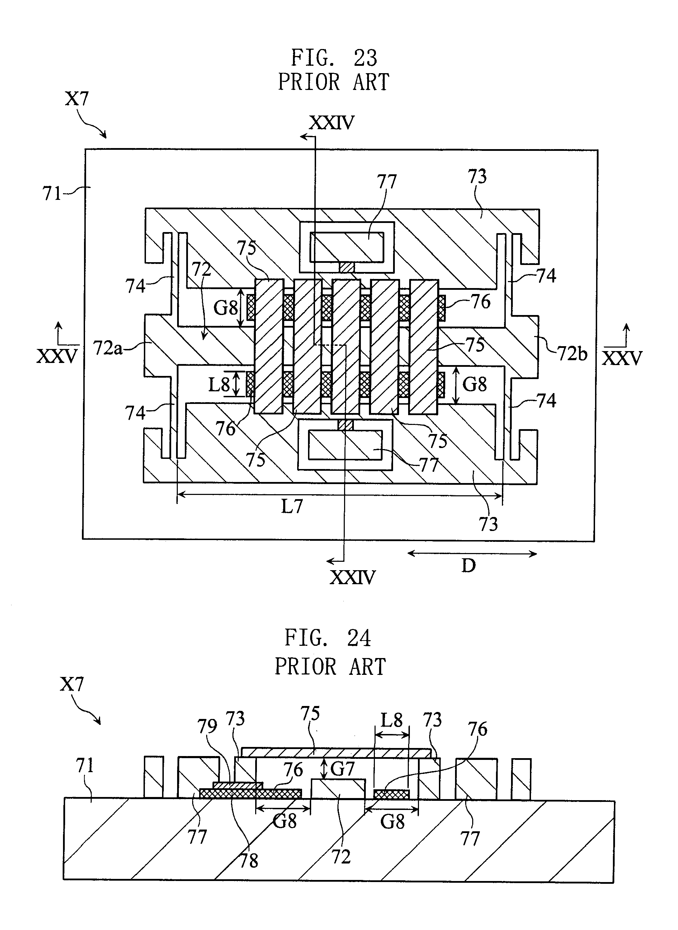

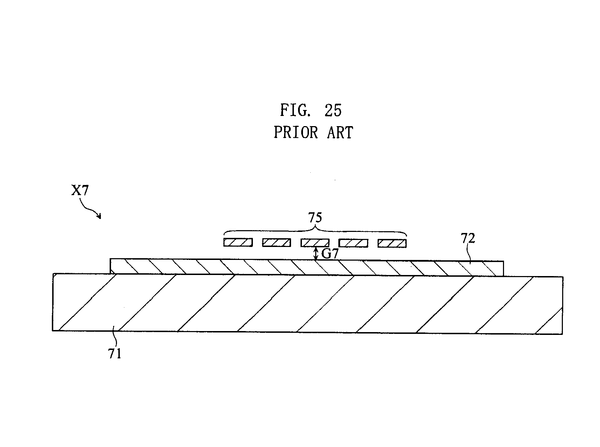

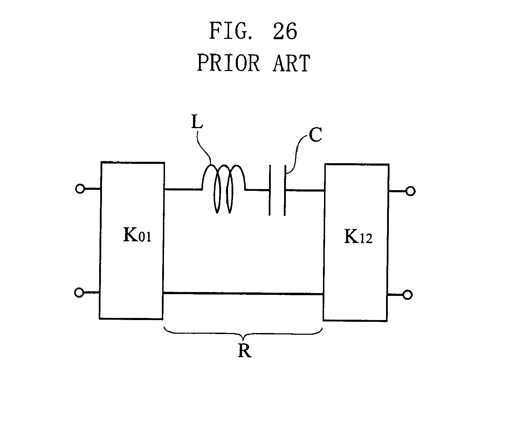

Fig. 23 to Fig. 26 show a variable filter element X7, which is an example of a conventional variable filter element. Fig. 23 is a plan view depicting variable filter element X7. Fig. 24 and Fig. 25 are enlarged cross-sectional views along at the XXIV - XXIV line and XXV - XXV line in Fig. 23. Fig. 26 is an equivalent circuit diagram depicting a distribution constant transmission line of the variable filter element X7.

The variable filter element X7 comprises a substrate 71, signal line 72, two ground lines 73, four shunt inductors 74, variable capacitor electrodes 75, drive electrodes 76 and electrode pads 77, and is constructed as a resonator filter for allowing the transmission of electromagnetic waves and electric signals in a predetermined high frequency band.

The substrate 71 is made of quartz or glass, and the signal line 72, ground lines 73, shunt inductors 74, movable capacitor electrodes 75, drive electrodes 76 and electrode pads 77 are all formed on the substrate 71.

The signal line 72 is a conductor pattern which has a terminal portion 72a (including end) and terminal portion 72b (outgoing end) on both ends, so that the electric signal passes between the terminal portions 72a and 72b, and includes an indicator component in this element, that is, a high frequency filter. This element is connected with circuits, not illustrated in drawings or other elements, via the terminal portions 72a and 72b. This signal line 72 is a distributed constant line of which impedance is 50 Ω for example, and is formed of Au.

Each ground line 73 is a conductor pattern which extends along the signal line 72, and is connected to the ground. This ground line 73, along with the signal line 72, constitutes a capacity fixed capacitor. The signal line 72 and each ground line 73 are connected via the shunt inductor 74. The ground line 73 and the shunt inductor 74 are formed of Au.

The movable capacitor electrode 75 bridges the ground lines 73 and has a portion facing the signal line 72, as shown in Fig. 24. The movable capacitor electrode 75 is formed of Au thin film. The movable capacitor electrode 75 and the signal line 72 constitute a capacitor variable capacitor.

Each drive electrode 76 is for generating electrostatic attraction with the movable capacitor electrode 75 so as to displace the movable capacitor electrode 75, and is disposed between the signal line 72 and the ground line 73, and faces a part of the movable capacitor electrode 75. The driving electrode 76 is formed of SiCr thin film.

The electrode pad 77 is a terminal for applying the drive voltage, and is separated from the ground line 73 via a gap. The electrode pad 77 and the drive electrode 76 are connected by an interconnect 78 which passes between the substrate 71 and the ground line 73, as shown in Fig. 24. The interconnect 78 and the ground line 73 are electrically isolated by an insulation film 79 which exists there between.

The variable filter element X7 having the above structure can be depicted by the equivalent circuit diagram shown in Fig. 26, which is comprised of a K₀₁ inverter, K₁₂ inverter and resonance circuit portion R disposed there between. The K₀₁ inverter is comprised of a pair of shunt inductors 74 which are connected to the signal line 72 at the terminal portion 72a (incoming end) side. The K₁₂ inverter is comprised of a pair of shunt inductors 74 which are connected to the signal line 72 at the terminal portion 72b (outgoing end) side. The resonance circuit portion R includes an inductor L (inductor component for entire resonance circuit portion R) and a capacity variable capacitor C (capacitor component of the entire resonance circuit portion R), and is mainly comprised of substrate 1, signal line 72 and ground line 73. The capacitor C is comprised of the above mentioned capacity fixed capacitor which is comprised of the signal line 72 and ground line 73 formed on substrate 1, and the above mentioned capacity variable capacitor which is comprised of the signal line 72 (immovable capacitor electrode) and a movable capacitor electrode 75. The spatial length L7 shown in Fig. 23 is set so that the transmission line length of the resonance circuit portion R shown in Fig. 26 (that is, the transmission length between the inverters) becomes a multiple of λ/2 (λ: wavelength of an extraction target, a predetermined high frequency, in a distributed constant line). In this configuration, in the variable filter element X7, mixed electric signals, which are input from the terminal portion 72a, are filtered, and electric signals in a predetermined high frequency band are extracted and output from the terminal portion 72b.

In the variable filter element X7, the electrostatic capacity of the capacitor C shown in Fig. 26 can be changed by applying a predetermined voltage (drive voltage) between the drive electrode 76 and the movable capacitor electrode 75. The potential application to the drive electrode 76 will be implemented via the electrode pad 77 and the interconnect 78. If the drive voltage is applied between the drive electrode 76 and the movable capacitor electrode 75, a predetermined electrostatic attraction is generated between these electrodes, and a predetermined movable capacitor electrode 75 is pulled toward the drive electrode 76 side for a predetermined amount, and as a result, the separation between the signal line 72 and the movable capacitor electrode 75 and the gap G7 shown in Fig. 24 and Fig. 25 decreases. If the gap G7 decreases, the electrostatic capacity of the capacitor C increases, the entire transmission line length of the variable filter element X7 increases equivalently or substantially, and the frequency band, which is allows to pass, shifts to the lower frequency side. In this variable filter element X7, the passing frequency band in the high frequency area can be switched (e.g. switching between 18 GHz and 22 GHz) by intentionally switching the capacity of the capacitor C shown in Fig. 26 using the ON/OFF of the drive voltage.

However, in the case of this conventional variable filter element X7, a relatively high drive voltage tends to be demanded for switching the passing frequency band. The size of the gap G8, shown in Fig. 23 and Fig. 24, between the signal line 72 and the ground line 73, is determined by the relationship with the dielectric constant of the material constituting the substrate 71, and in the case of the variable filter element X7, the gap G8 is limited to a relatively small size, and the length L8 of the drive electrode 76 shown in Fig. 23 and Fig. 24 is limited to be short (e.g. if the substrate material is quartz, the signal line material is Au, the signal line width is 160 µm and the signal line is a CPW transmission line with a 77 Ω impedance, then the size of the gap G8 is about 80 µm). Limiting the length L8 of the drive electrode 76 to be short means limiting the area of the drive electrode 76 per unit length in a direction indicated by the arrow mark D in Fig. 23. In other words, in order to secure a sufficient drive force (electrostatic attraction) that should be generated between the drive electrode 76 and the movable capacitor electrode 75 in the variable filter element X7, it is difficult to depend only on the method of securing a sufficient size area of the drive electrode 76, and it is necessary to secure sufficient drive voltage which is applied between the drive electrode 76 and the movable capacitor electrode 75. For example, in order to execute the above mentioned switching between 18 GHz and 22 GHz in the variable filter element X7, about 80V of high drive voltage is required. High drive voltage is not desirable, and particularly in the compact radio communication equipment application field, such as a portable telephone of which power supply is a battery, decreasing the drive voltage is strongly demanded.

### SUMMARY OF THE INVENTION

With the foregoing in view, it is an object of the present invention to provide a variable filter element and variable filter module which are suitable for decreasing the drive voltage, and a fabrication method thereof.

According to the first aspect of the present invention, a variable filter element is provided. This variable filter element comprises: a substrate; two ground lines on the substrate, and a signal line between the ground lines on the substrate, which are disposed to extend in parallel on the substrate; movable capacitor electrodes which bridge between the two ground lines on the substrate and have portions facing the signal line; drive electrodes which are located between the signal line and the ground lines on the substrate, and generate electrostatic attraction with the movable capacitor electrodes; and a ground line, in the substrate, which is disposed in the substrate, has a portion facing the signal line, and is electrically connected with the two ground lines on the substrate. The ground line on the substrate, the movable capacitor electrodes and the ground line in the substrate constitute a ground interconnection portion. The signal line and the ground interconnection portion constitute a distributed constant transmission line. In this element, it can be assumed that the signal line and the ground interconnection portion constitute a single capacity variable capacitor, the signal line and the ground lines on the substrate constitute a capacity fixed capacitor (first capacitor), the signal line and the movable capacitor electrodes constitute a capacity variable capacitor (second capacitor), and the signal line and the ground line in the substrate constitute a capacity fixed capacitor (third capacitor). In other words, it is assumed that the distributed constant transmission line of this element has a single capacity variable capacitor, the first capacitor comprised of the signal line and the ground line on the substrate becomes a part of this capacity variable capacitor, the second capacitor comprised of the signal line and the variable capacitor electrodes becomes a part of this capacity variable capacitor, and the third capacitor comprised of the signal line and the ground line in the substrate also becomes a part of this capacity variable capacitor. The third capacitor has a function to compensate for the contribution of the first capacitor and the second capacitor to the electrostatic capacity of this capacity variable capacitor.

In this variable filter element, the electrostatic capacity of the capacity variable capacitors (including the first - third capacitors) can be changed by applying a predetermined voltage (drive voltage) between the drive electrode and the movable capacitor electrode. If the drive voltage is applied between the drive electrode and the movable capacitor electrode, a predetermined electrostatic attraction is generated between these electrodes, and the movable capacitor electrode is pulled toward the drive electrode side for a predetermined amount, and as a result, the separation or the gap between the signal line and the movable capacitor electrode decreases. If the gap decreases, the electrostatic capacity of the capacity variable capacitor increases, the entire transmission line length of this element increases equivalently or substantially, and the frequency band, which is allowed to pass, shifts to the lower frequency side. By adjusting the drive voltage to be applied, the passing frequency band can be controlled.

As described above, according to the present variable filter element, the third capacitor (comprised of the signal line and the ground line in the substrate) has a function to compensate the contribution of the first capacitor and second capacitor to the electrostatic capacity of the capacity variable capacitor of the distributed constant transmission line formed by this element. Therefore, unlike the above mentioned conventional variable filter element X7 where the size of the gap G8 between the signal line 72 and the ground line 73 is limited to a relatively small value, the size of the gap between the signal line and the ground line on the substrate can be set to a relatively large value in the present element. (The contribution of the first capacitor to the electrostatic capacity decreases as this gap size increases, but this decreases can be compensated by the third capacitor.) In the present element, in which the size of the gap between the signal line and the ground line on the substrate can be set to a relatively large value, a sufficient area of the drive electrode for allowing movement of the movable capacitor electrode can be easily secured. Therefore this variable filter element can easily decrease the drive voltage to be applied between the signal line and the movable capacitor electrode. Decreasing the drive voltage is desirable for the compact radio communication equipment application field, such as portable telephones, of which power supplies are batteries.

According to a second aspect of the present invention, a variable filter element is provided. This variable filter element comprises: a substrate; signal lines disposed to extend in parallel on the substrate; movable capacitor electrodes which protrude on the substrate and have portions facing the signal lines; drive electrodes which are formed on the substrate and generate electrostatic attraction with the movable capacitor electrodes; and a ground line, in the substrate, which is disposed in the substrate, has portions facing the signal lines and is electrically connected with the movable capacitor electrodes. The movable capacitor electrodes and the ground line in the substrate constitute a ground interconnection portion. The signal lines and the ground interconnection portions constitute a distributed constant transmission line. In this element it can be assumed that the signal line and the ground interconnection portion constitute a single capacity variable capacitor, the signal line and the movable capacitor electrode constitute a capacity variable capacitor (first capacitor), and the signal line and the ground line in the substrate constitute a capacity fixed capacitor (second capacitor). In other words, if it is assumed that the distributed constant transmission line of this element has a single capacity variable capacitor, the first capacitor comprised of the signal line and the movable capacitor electrode becomes a part of this capacity variable capacitor, and the second capacitor comprised of the signal line and the ground line in the substrate also becomes a part of this capacity variable capacitor.

The variable filter element according to the second aspect can be driven by applying the drive voltage between the drive electrode and the movable capacitor electrode, just like the variable filter element according to the first aspect.

The present element does not have a configuration where a signal line is disposed between the two ground lines on the substrate which are disposed in parallel. Therefore unlike the above mentioned conventional variable filter element X7, where the size of the gap G8 between the signal line 72 and the ground line 73 is limited to a relatively small value, thereby the area of the driving electrode 76 being relatively constrained, a wide area can be easily provided for the drive electrode on the substrate in the case of the present element. Hence in the present variable filter element, the drive voltage to be applied between the signal line and the movable capacitor electrode can be easily decreased. Decreasing the drive voltage is desirable for decreasing power consumption, for example.

The variable filter element according to the second aspect of the present invention may further comprise a ground line on the substrate which is disposed in parallel with the signal line on the substrate, and is electrically connected with the ground line in the substrate.

Preferably, the variable filter element according to the first and second aspects of the present invention further comprises a dielectric portion on the signal line. This dielectric portion is for preventing a short circuit of the signal line and the movable capacitor electrode, and for increasing the electrostatic capacity of the capacitor constructed by the signal line and the movable capacitor electrode. Increasing the electrostatic capacity is desirable to secure a wide frequency variable range for this element.

Preferably, the substrate is a multilayer interconnection substrate which has a layered structure comprising a plurality of insulation layers and interconnection pattern between each insulation layer. Preferably, the ground line in the substrate is included in an interconnection pattern closest to the signal line on the multilayer interconnection substrate. Preferably, the insulation layer is made of ceramic. The ground line in the substrate according to the present invention is preferably disposed in this multilayer interconnection substrate.

Preferably, the variable filter element according to the first and second aspects further comprises electrode pads for external connection on an opposite surface from the signal line on the substrate. Preferably, the variable filter element further comprises a conductive connection portion which penetrates through the substrate.

According to a third aspect of the present invention, a variable filter element is provided. This variable filter element comprises a plurality of variable filter elements according to the first or second aspect, wherein the plurality of variable filter elements are disposed in series or in parallel.

According to the fourth aspect of the present invention, a variable filter module is provided. This variable filter module comprises the variable filter element according to the first, second or third aspect of the present invention, and a plurality of passive elements disposed on the substrate. Each passive element is an inductor, capacitor or resistor.

According to a fifth aspect of the present invention, a method for fabricating the variable filter element according to the first, second or third aspect is provided. This fabrication method comprises a wafer fabrication step, element formation step and separation step. In the wafer fabrication step, an interconnection substrate wafer which has a plurality of variable filter module formation blocks, each of which includes a ground line in the substrate, is fabricated. In the element formation step, at least a signal line, drive electrodes and variable capacitor electrodes are formed on the interconnection substrate wafer in each of the plurality of variable filter module formation blocks. In the separation step, the interconnection substrate wafer is separated. By this method, the variable filter elements according to the first, second or third aspect of the present invention can be appropriately mass produced using the interconnection substrate wafer having the variable filter module formation blocks.

According to a sixth aspect of the present invention, a method for fabricating the variable filter module according to the fourth aspect is provided. This fabrication method comprises a wafer fabrication step, an element formation step and a separation step. In the wafer fabrication step, an interconnection substrate wafer, which has a plurality of variable filter module formation blocks, each of which includes a ground line in the substrate, is fabricated. In the element formation step, at least a signal line, drive electrodes, variable capacitor electrodes, and a plurality of passive element groups are formed on the interconnection substrate wafer in each of the plurality of variable filter module formation blocks. In the separation step, the interconnection substrate wafer is separated. By this method, the variable filter module according to the fourth aspect of the present invention can be appropriately mass produced using the interconnection substrate wafer having the variable filter module formation blocks.

Preferably, the fabrication method according to the fifth and sixth aspects of the present invention further comprises a step of installing a sealing cap for each formation block before the separation step. In this way, a wafer level packaging may be performed.

### BRIEF DESCRIPTION OF THE DRAWINGS

Fig. 1 is a partially omitted plan view depicting a variable filter element according to the first embodiment of the present invention;
Fig. 2 is an enlarged cross-sectional view along the II-II line in Fig. 1;
Fig. 3 is an enlarged cross-sectional view along the III-III line in Fig. 1;
Fig. 4 is an equivalent circuit diagram depicting a distributed constant transmission line formed by the variable filter element shown in Fig. 1;
Fig. 5 shows a part of the steps of a fabrication method for the variable filter element in Fig. 1;
Fig. 6 shows steps continuing from Fig. 5;
Fig. 7 shows steps continuing from Fig. 6;
Fig. 8 shows steps continuing from Fig. 7;
Fig. 9 shows smoothing processing steps;
Fig. 10 is a partially omitted plan view depicting a variable filter element according to the second embodiment of the present invention;
Fig. 11 is an enlarged cross-sectional view along the XI-XI line in Fig. 10;
Fig. 12 is an equivalent circuit diagram depicting a distributed constant transmission line formed by the variable filter element shown in Fig. 10 (partially omitted);
Fig. 13 is a partially omitted plan view depicting a variable filter element according to the third embodiment of the present invention;
Fig. 14 is an enlarged partial cross-sectional view along the XIV-XIV line in Fig. 13;
Fig. 15 is an equivalent circuit diagram depicting a distributed constant transmission line formed by the variable filter element shown in Fig. 13 (partially omitted);
Fig. 16 is a partially omitted plan view depicting a variable filter element according to the fourth embodiment of the present invention;
Fig. 17 is an enlarged cross-sectional view along the XVII-XVII line in Fig. 16;
Fig. 18 is an enlarged cross-sectional view along the XVIII-XVIII line in Fig. 16;
Fig. 19 is a partially omitted plan view depicting a variable filter element according to the fifth embodiment of the present invention;
Fig. 20 is an enlarged cross-sectional view along the XX-XX line in Fig. 19;
Fig. 21 is a partially omitted plan view depicting a variable filter element according to the sixth embodiment of the present invention;
Fig. 22 is an enlarged partial cross-sectional view along the XXII-XXII line in Fig. 21;
Fig. 23 is a plan view depicting a conventional variable filter element;
Fig. 24 is an enlarged cross-sectional view along the XXIV-XXIV line in Fig. 23;
Fig. 25 is an enlarged cross-sectional view along the XXV-XXV line in Fig. 23; and
Fig. 26 is an equivalent circuit diagram depicting a distributed constant transmission line formed by the variable filter element shown in Fig. 23.

### DETAILED DESCRIPTION OF THE PREFERRED EMBODIMENTS

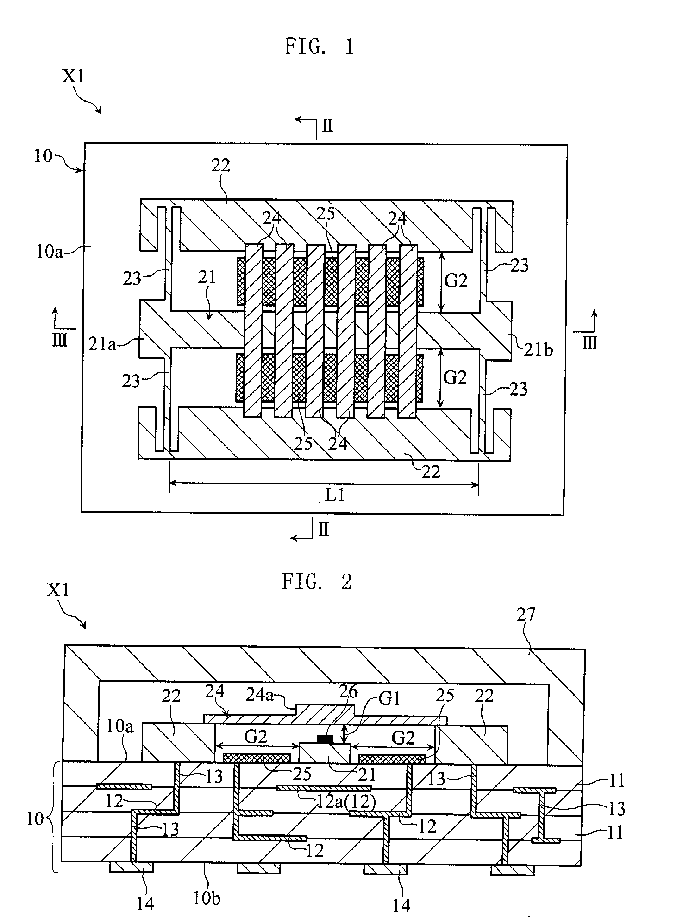

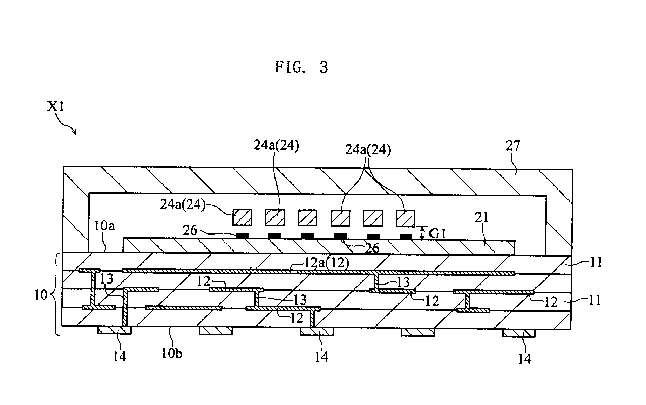

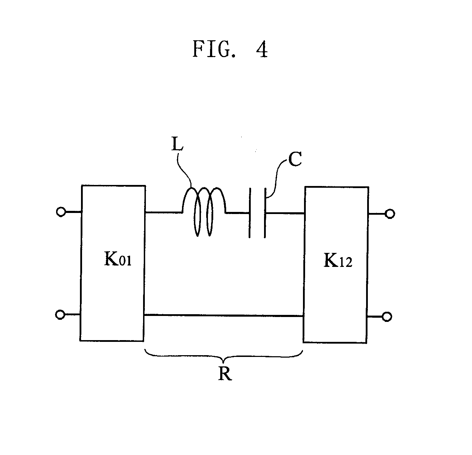

Fig. 1 to Fig. 4 show a variable filter element X1 according to a first embodiment of the present invention. Fig. 1 is a partially omitted plan view of the variable filter element X1. Fig. 2 and Fig. 3 are enlarged cross-sectional views along the II-II line and III-III line in Fig. 1. Fig. 4 is an equivalent circuit diagram depicting a distributed constant transmission line formed by the variable filter element X1.

The variable filter element X1 comprises an interconnection substrate 10, signal line 21, two ground lines 22, four shunt inductors 23, movable capacitor electrodes 24, drive electrodes 25, dielectric dot 26 and packaging element 27 (not shown in Fig. 1), and is constructed as a resonator filter which allows passing electromagnetic waves or electric signals in a predetermined high frequency band.

The interconnection substrate 10 is a multilayer ceramic interconnection substrate, and has a first face 10a and a second face 10b, as shown in Fig. 2 and Fig. 3, and has insulation layers 11, interconnection patterns 12, vias 13 and electrode pads 14 for external connection. Each insulation layer 11 is a ceramic layer of Al₂O₃, for example. Each interconnection pattern 12 is formed of such low resistance metal as Cu, Ag, W and Mo, and is buried in the insulation layer 11. A part of the interconnection pattern 12 positioned closest to the first face 10a becomes a ground line 12a connected to the ground. The ground line 12a corresponds to "the ground line in the substrate" in the present invention. Each via 13 is formed of such low resistance metal as Cu, A, W and Mo. Each electrode pad 14 is positioned in an array on the second face 10b, and is formed of Cu, for example. The vias 13 connect between the interconnection patterns 12, between the interconnection pattern 12 and the electrode pad 14, between the interconnection pattern 12 and the signal line 21, and between the interconnection pattern 12 and the ground line 22.

The signal line 21 is a conductive pattern having a terminal portion 21a (incoming end) and a terminal portion 21b (outgoing end) at each end, where electric signals pass between these terminal portions 21a and 21b, and includes an inductor component of this element, which is a high frequency filter. The terminal portions 21a and 21b are electrically connected to predetermined electrode pads 14 via predetermined vias 13 and interconnection patterns 12 in the interconnection substrate 10. This signal line 21 is formed of such low resistance metal as Cu, Ag, W and Mo.

Each ground line 22 is disposed along the signal line 21, and are electrically connected to predetermined electrode pads 14 via predetermined vias 13 and interconnection patterns 12 in the interconnection substrate 10, and is connected to the ground. This ground line 22 corresponds to the "ground line on the substrate" in the present invention, and this ground line 22 along with the signal line 21 constitute a capacity fixed capacitor. The signal line 21 and each ground line 22 are connected by the shunt inductors 23. The ground lines 22 and the shunt inductors 23 are formed of such low resistance metal as Au, Cu and Al.

Each movable capacitor electrode 24 bridges between the ground lines 22 (connected to the ground) as shown in Fig. 2, and have a thick portion 24a which faces the signal line 21. The movable capacitor electrodes 24 are formed of such low resistance metal as Au, Cu and Al. The movable capacitor electrodes 24 along with the signal line 21 constitute a capacity variable capacitor. The movable capacitor electrodes 24 and the ground lines 12a and 22 constitute the "ground interconnection portion" of the present invention.

Each drive electrode 25 generates an electrostatic attraction with the movable capacitor electrode 24 so as to displace the movable capacitor electrode 24, and is disposed between the signal line 21 and the ground line 22, and faces a part of the movable capacitor electrode 24. The drive electrode 25 is formed of a predetermined metal thin film (SiCr thin film of which resistance is relatively high, and is desirable in terms of preventing a leak of high frequency signals).

The dielectric dot 26 is formed on the signal line 21, as shown in Fig. 2 and Fig. 3, and is formed of such dielectric material as Al₂O₃, SiO₂, SixNy and SiOC. This dielectric dot 26 is for preventing a short circuit of the signal line 21 and the movable capacitor electrode 24, and also for increasing the electrostatic capacity of the capacitor constructed by the signal line 21 and the movable capacitor electrodes 24. Increasing the electrostatic capacity is desirable for securing a wide frequency variable area for this element.

The packaging element 27 is for sealing various structures on the first face 10a of the interconnection substrate 10, and is bonded to the first face 10a. The packaging element 27 is formed of a metal Si, or a resin sealing substance, for example.

The variable filter element X1 having this structure can be represented by an equivalent circuit diagram comprised of a K₀₁ inverter, a K₁₂ inverter and a resonance circuit portion R disposed there between, as shown in Fig. 4. The K₀₁ inverter is comprised of a pair of shunt inductors 23 which are connected to the signal line 21 at the terminal portion 21a (incoming end) side. The K₁₂ inverter is comprised of a pair of shunt inductors 23 which are connected to the signal line 21 at the terminal portion 21b (outgoing end) side. The resonance circuit portion R includes an inductor L (inductor component in the entire resonance circuit portion R) and a capacity variable capacitor C (capacitor component in the entire resonance circuit portion R), and is mainly comprised of an interconnection substrate 10 or insulation layer 11, signal line 21, and ground interconnection portion (ground lines 12a, 22 and movable capacitor electrodes 24). The capacitor C is comprised of the signal line 21 and the ground interconnection portion, and more specifically, includes the capacity fixed capacitor (first capacitor) comprised of the signal line 21 and the ground line 22 (ground line on the substrate), the capacity variable capacitor (second capacitor) comprised of the signal line 21 and the movable capacitor electrodes 24, and the capacity fixed capacitor (third capacitor) comprised of the signal line 21 and the ground line 12a (ground line in the substrate). In other words, if it is assumed that the distributed constant transmission line formed by the variable filter element X1 has a single capacity variable capacitor C, the first capacitor comprised of the signal line 21 and the ground line 22 becomes a part of this capacitor C, the second capacitor comprised of the signal line 21 and the movable capacitor electrode 24 becomes a part of this capacitor C, and in addition, the third capacitor comprised of the signal line 21 and the ground line 12a also becomes a part of the capacitor C. The third capacitor has a function to compensate the contribution of the first capacitor and the second capacitor to the electrostatic capacity of the capacitor C.

In the variable filter element X1, the spatial length L1 shown in Fig. 1 is set so that the transmission line length of the resonance circuit portion R shown in Fig. 4 (that is, transmission line length between both inverters) becomes a multiple of λ/2 (λ: wavelength of extraction target, a predetermined high frequency, on the distributed constant line). In other words, in the variable filter element X1, mixed electric signals which are input from the terminal portion 21a, for example, via predetermined electrode pads 14, vias 13 and interconnection patterns 12, are filtered, and electric signals in a predetermined high frequency band are output from the terminal portion 12b, or predetermined electrode pad 14 connected thereto.

In the equivalent circuit diagram in Fig. 4, the resonance circuit portion R is disposed between the K₀₁ inverter and the K₁₂ inverter, and according to this configuration, electromagnetic waves or high frequency electric signals can be entered into the resonance circuit portion R from the incoming end (K₀₁ inverter side terminal) without reflection, and electromagnetic waves which propagate to the outgoing end (K₁₂ inverter side terminal) can be emitted from this outgoing end without reflection. The K₀₁ inverter has a characteristic impedance K₀₁, and the K₁₂ inverter has a characteristic impedance K₁₂, and both function as a distributed constant line with a λ/4 length in a predetermined frequency band respectively.

In the variable filter element X1, the capacity of the capacitor C (first - third capacitors) shown in Fig. 4 can be changed by applying a predetermined voltage (drive voltage) between the drive electrodes 25 and the movable capacitor electrodes 24. Applying a potential to the drive electrodes 25 can be implemented via a conductive path which is comprised of predetermined electrode pads 14, vias 13 and interconnection patterns 12. If the drive voltage is applied between the drive electrode 25 and the movable capacitor 24, a predetermined electrostatic attraction is generated between these electrodes, the movable capacitor electrode 24 is pulled toward the drive electrode 25 side for a predetermined amount, and as a result, the separation between the signal line 21 and the movable capacitor electrode 24, or the gap G1 shown in Fig. 2 and Fig. 3, decreases. If the gap G1 decreases, the electrostatic capacity of the capacitor C increases, and the entire transmission line length of the variable filter element X1 increases equivalently or substantially, and a frequency band, which is allowed to pass, shifts to the lower frequency side. In this variable filter element X1, the passing frequency band can be controlled by adjusting the drive voltage to be applied. For example, the capacity of the capacitor C shown in Fig. 4 can be intentionally switched so as to switch the passing frequency band in the high frequency area appropriately (e.g. switching between 18 GHz and 22 GHz) using ON/OFF of the drive voltage. It is also possible to continuously change the passing frequency band by analog-controlling the drive voltage.

As des,cribed above, according to the variable filter element X1, the third capacitor (comprised of the signal line 21 and the ground line 12a) has a function to compensate the contribution of the first capacitor and the second capacitor to the electrostatic capacity of the capacity variable capacitor C of the distributed constant transmission line formed by this element. Therefore, unlike the above mentioned conventional variable filter element X7, where the size of the gap G8 between the signal line 72 and the ground line 73 is limited to a relatively small value, the size of the gap G2 between the signal line 21 and the ground line 22 (ground line on the substrate), shown in Fig. 1 and Fig. 2, can be set to a relatively large value in the present element (the contribution of the first capacitor to the total electrostatic capacity decreases as the gap size increases, but this decrease can be compensated by the electrostatic capacity of the third capacitor). In the present element in which the size of the gap G2 between the signal line 21 and the ground line 22 can be set to a relatively large value, a sufficient area of the drive electrode 25, for allowing movement of the movable capacitor electrode 24, can be easily secured. Therefore this variable filter element X1 can easily decrease the drive voltage to be applied between the signal line 21 and the movable capacitor electrodes 24. Decreasing the drive voltage is desirable for the compact radio communication equipment application field, such as portable telephones, of which power supplies are batteries.

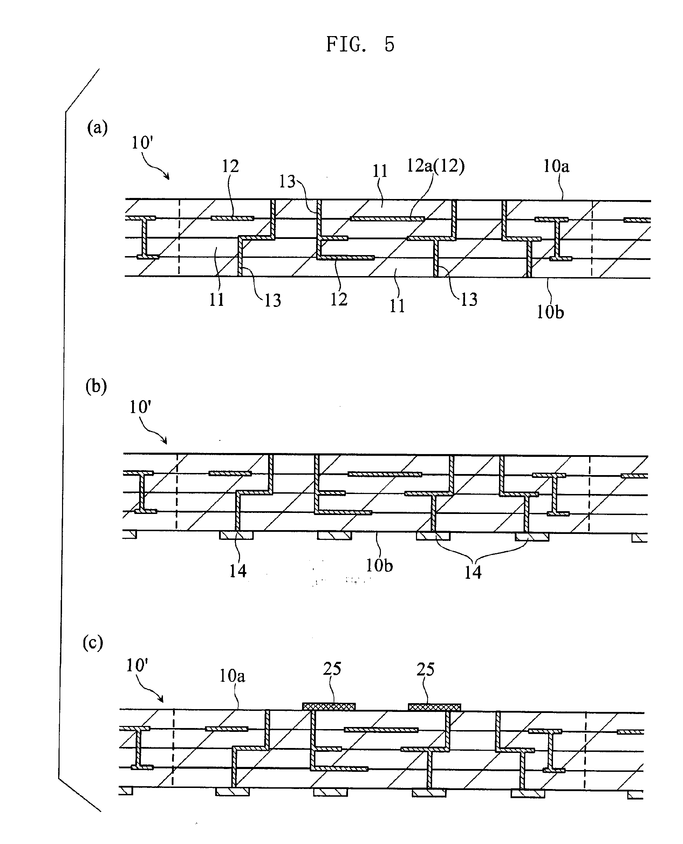

Fig. 5 to Fig. 8 shows an example of a fabrication method of the variable filter element X1. In Fig. 5 to Fig. 8, the fabrication steps of the variable filter element X1 are shown by the changes in the cross-sections. These cross-sections include a cross section of a single variable filter element formation block (corresponds to the cross-section shown in Fig. 2) of a wafer to be processed.

In the fabrication of the variable filter element X1, an interconnection substrate wafer 10' shown in Fig. 5(a) is fabricated first. The interconnection substrate wafer 10' is a wafer having a first face 10a and a second face 10b, which has a multilayer interconnection structure comprising an insulation layer 11, interconnection patterns 12 (including a ground line 12a) and vias 13, and includes a plurality of variable filter element formation blocks. The surface roughness Rz of the first face 10a of the interconnection substrate wafer 10' is 0.2 µm or less.

In the fabrication of the interconnection substrate wafer 10', openings for vias are formed in each of a plurality of ceramic substrates, that is green sheets, are used, then conductive paste is filled into the openings for vias, and also interconnection patterns are printed on the surface of the ceramic substrates using the conductive paste. A predetermined number of ceramic substrates prepared by such steps are layered, and this layered product is pressed in the thickness direction while heating. After this, this layered product is baked by a predetermined heating processing, and the pre-interconnection substrate wafer 10" is obtained. (By the baking, the interconnection patterns 12 and the vias 13 are formed.)

In the next step of the interconnection substrate wafer 10', both faces of the pre-interconnection substrate wafer 10" are polished. For the polishing, a mechanical polishing using a predetermined abrasive (chemical), for example, can be used. By this polishing processing, warp and waviness of the pre-interconnection substrate wafer 10" are decreased. In this polishing processing, Preferably, the warp is decreased to be 40 µm or less, and waviness is sufficiently decreased.

In the next step of the fabrication of the interconnection substrate wafer 10', the first face 10a, that is, the face on which the above mentioned signal lines 21 and the ground line 22 are formed, of the pre-interconnection substrate wafer 10" is smoothed. Since bumps (generated due to the size of the constituent ceramic particles, the presence of voids between ceramic particles and the polishing effect caused by the abrasive) exist on the surface of the pre-interconnection substrate wafer 10' obtained as mentioned above, it is inevitable that dents with about a 5 µm depth are actually generated on the surface of the pre-interconnection substrate wafer 10" even if the selection of the ceramic material and polishing method are optimized. On a surface having such bumps, a small sized passive element, such as a filter element, cannot be formed appropriately, so a predetermined smoothing processing is required after the above mentioned polishing processing, when the interconnection substrate wafer 10" is fabricated.

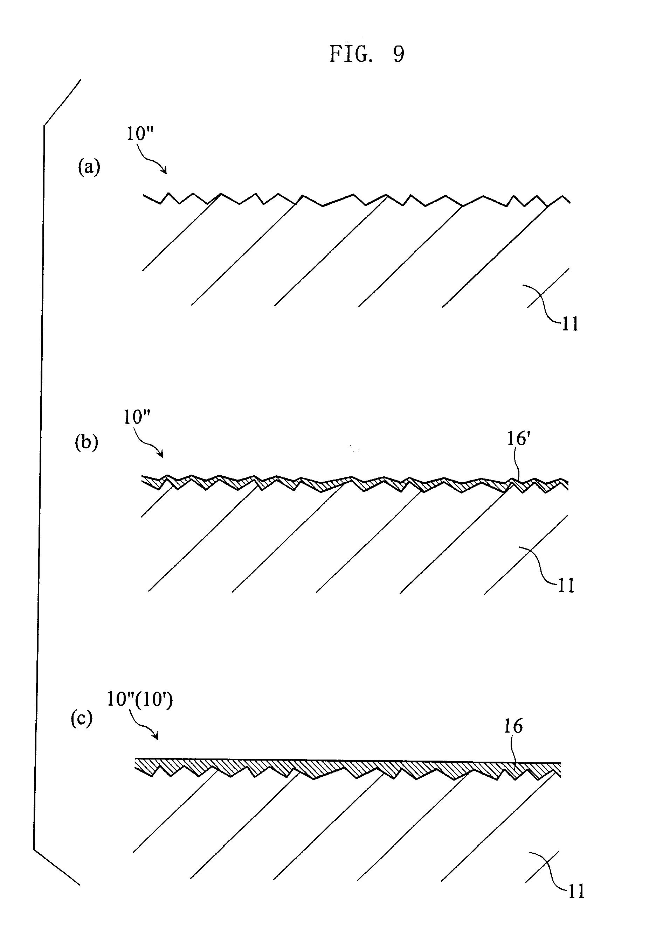

Fig. 9 shows the steps of the smoothing processing. Fig. 9 shows an enlarged partial cross-sectional view around the surface of the pre-interconnection substrate wafer 10" where the smoothing processing is performed. In this smoothing processing, a thin insulation film 16' is formed, as shown in Fig. 9(b), on a bumpy surface shown in Fig. 9(a), on the pre-interconnection substrate wafer 10" or the insulation layer 11 on the surface after receiving the above mentioned polishing processing. To form the insulation film 16', an insulation coating solution is thinly coated onto the surface of the pre-interconnection substrate wafer 10", and [the pre-interconnection substrate wafer 10"] is baked. For the insulation coating solution, SOG (Spin-On-Glass), for example, can be used. The thickness of the insulation coating solution to be coated is 1 µm or less, for example. By forming a thin insulation film 16' like this, the dents on the surface of the pre-interconnection substrate wafer 10" can be decreased. Then this insulation film formation step is repeated for a predetermined number of times, and as Fig. 9(c) shows, the protruding portions on the surface of the ceramic substrate of the pre-interconnection substrate wafer 10" are buried under the insulation film 16 which is formed by layering the insulation film 16'. (The insulation film 16 is not shown in drawings other than Fig. 9.) By the method shown in Fig. 9, the surface roughness Rz of the entire first face 10a can be decreased to be 0.05 µm or less. By performing this smoothing processing after the above mentioned polishing processing, the interconnection substrate wafer 10' can be obtained.

In the next step of the fabrication of the variable filter element X1, electrode pads 14 are formed, as shown in Fig. 5(b), on the second face 10b of the interconnection substrate wafer 10' fabricated as above. For example, the electrode pads 14 can be formed by forming a film of a predetermined metal material on the second face 10b of the interconnection substrate wafer 10' by a sputtering method, and patterning this metal film by a predetermined wet etching or dry etching. An electroless plating method or electro-plating method may be used for forming the electrode pads 14.

Then as Fig. 5(c) shows, the above mentioned drive electrodes 25 are formed on the interconnection substrate wafer 10'. For example, the drive electrodes 25 can be formed by forming a film of a predetermined metal material on the interconnection substrate wafer 10' by a sputtering method, then patterning this metal film by a predetermined wet etching or dry etching. After this step, an insulation film is formed on a predetermined area so as to cover the drive electrodes 25 if necessary.

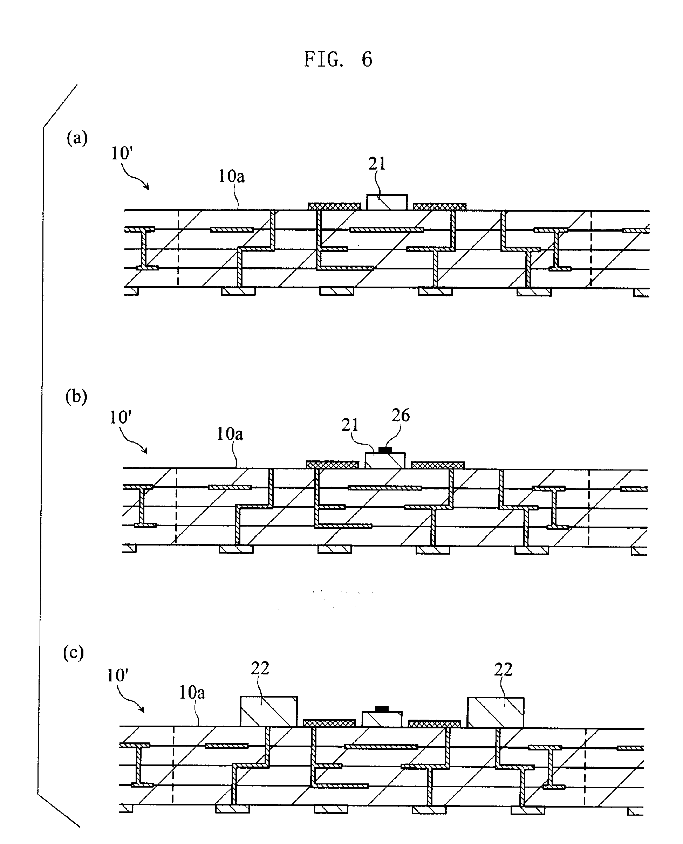

Then as Fig. 6(a) shows, the above mentioned signal line 21 is formed on the interconnection substrate wafer 10'. For example, the signal line 21 can be formed by forming a resist pattern having an opening corresponding to the signal line 21 on the interconnection substrate wafer 10' by patterning, and then depositing a predetermined metal material (e.g. Au) on the opening by a plating method (electroless plating or electro-plating).

Then as Fig. 6(b) shows, the above mentioned dielectric dot 26 is formed on the signal line 21. For example, the dielectric dot 26 can be formed by forming a predetermined dielectric film on the first face 10a side of the interconnection substrate wafer 10', then patterning this dielectric film.

Then as Fig. 6(c) shows, the above mentioned ground lines 22 are formed on the interconnection substrate wafer 10'. For example, the ground lines 22 can be formed by forming a resist pattern having openings corresponding to the ground lines 22 on the interconnection substrate wafer 10' by patterning, then deposing a predetermined metal material (e.g. Au) on these opening by a plating method (electroless plating or electro-plating).

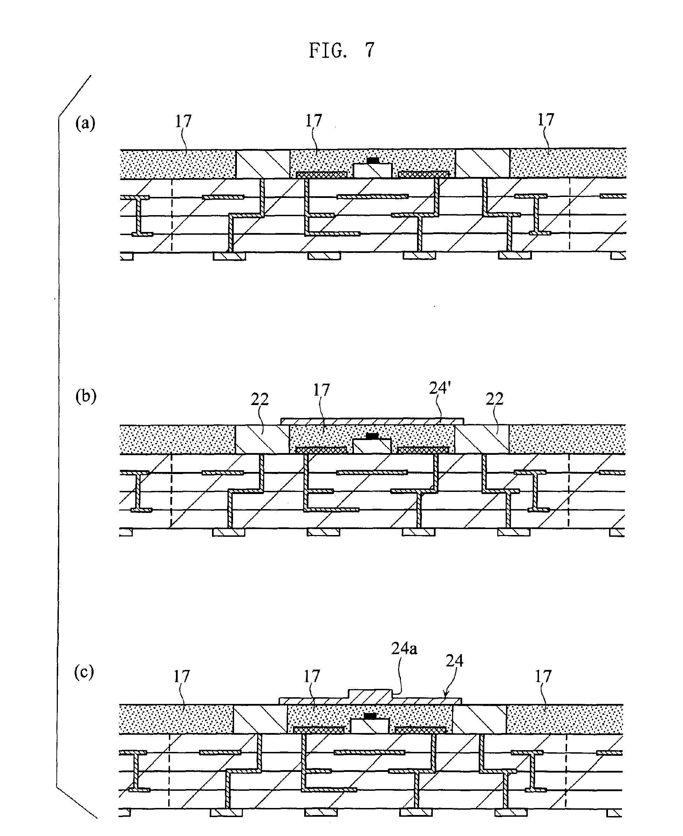

Then a sacrifice layer 17 is formed, as shown in Fig. 7(a). The sacrifice layer 17 is formed of a predetermined resist material.

Then as Fig. 7(b) shows, a part 24' of the above mentioned movable capacitor electrode 24 is formed on the sacrifice layer 17. For example, a part 24' of the movable capacitor electrode 24 is formed by forming a film of a predetermined metal material on the sacrifice layer 17 by a sputtering method, then patterning this metal film by a predetermined wet etching or dry etching. This part 24' may be formed by an electrolysis plating method or electro-plating method.

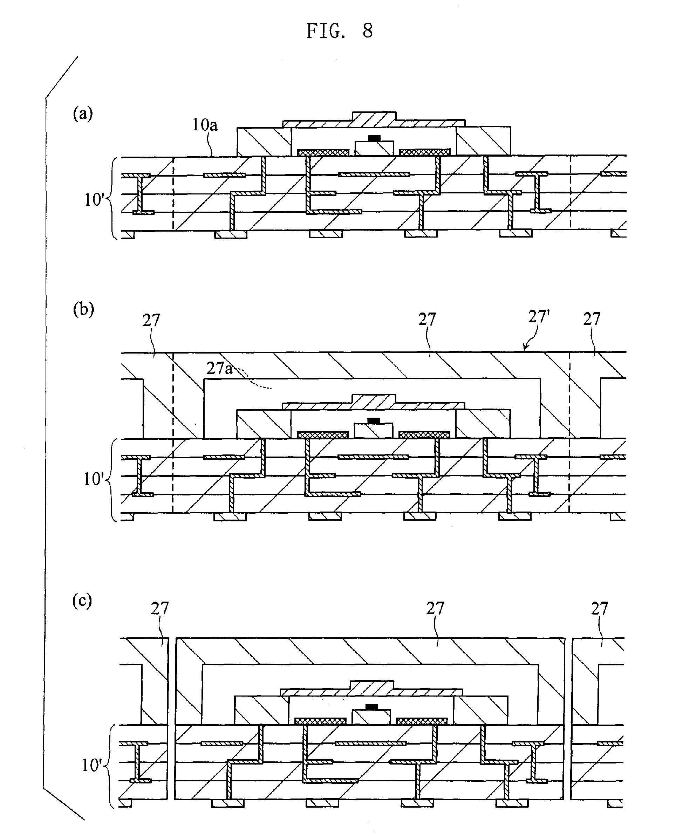

Then as Fig. 7(c) shows, a thick portion 24a of the movable capacitor electrode 24 is formed. For example, the thick portion 24a can be formed by forming a resist pattern having an opening corresponding to the thick portion 24a on the part 24' of the movable capacitor electrode 24 and the sacrifice layer 17 by patterning, then depositing a predetermined metal material (e.g. Au) in this opening by a plating method (electroless plating or electro-plating). Then the sacrifice layer 17 is removed, as shown in Fig. 8(a).

Then as Fig. 8(b) shows, a packaging wafer 27' is bonded on the first face 10a side of the interconnection substrate wafer 10'. Examples of the bonding method are, an anode bonding method, direct bonding method, cold bonding method and eutectic bonding method. The packaging wafer 27' is fabricated by processing a predetermined silicon wafer, and a concave portion 27a is formed, in advance, in an area corresponding to each variable filter element formation block of the interconnection substrate wafer 10'. The packaging wafer 27' substantially includes a plurality of the above mentioned packaging element 27.

Then as Fig. 8(c) shows, the layered product comprised of the interconnection substrate wafer 10' and the packaging wafer 27' is cut. In this way, the variable filter element X1 can be fabricated. According to this method, the variable filter element X1 can be appropriately mass produced by using an interconnection substrate wafer 10' having many variable filter element formation blocks.

The variable filter element X1 may be constructed as a variable filter module by using an interconnection substrate 10 having a sufficiently wide area, and forming various passive elements (e.g. inductor, capacitor, resistor) according to the circuit design on the first face 10a of this interconnection substrate 10. This variable filter module can be fabricated in the same way as the above mentioned steps, described with reference to Fig. 5(b) to Fig. 7(c) for the variable filter element X1, except for creating various passive elements on the interconnection substrate wafer 10'. It is the same for the following second to sixth embodiments that the variable filter element can be configured as a variable filter module or can be fabricated as a variable filter module.

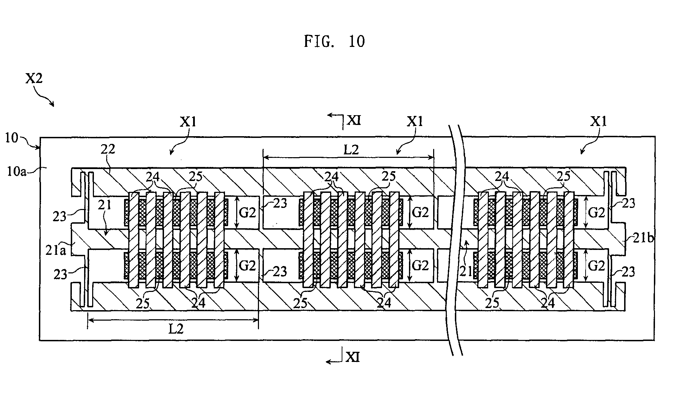

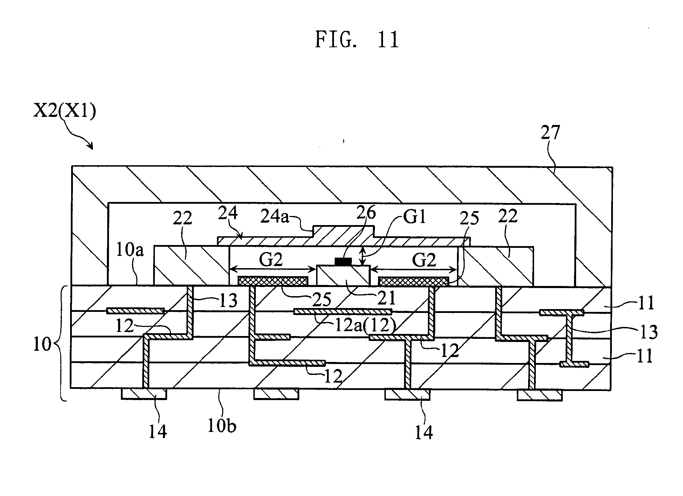

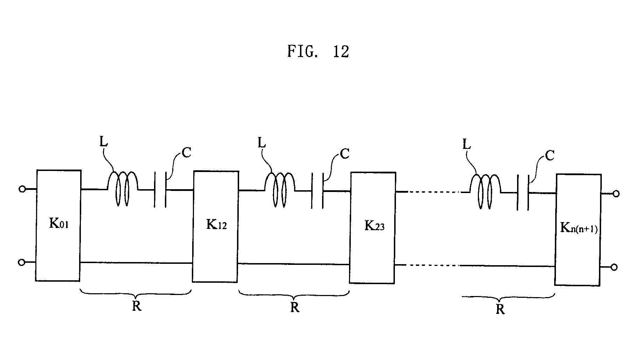

Fig. 10 to Fig. 12 show a variable filter element X2 according to the second embodiment of the present invention. Fig. 10 is a partially omitted plan view of the variable filter element X2. Fig. 11 is an enlarged cross-sectional view along the XI-XI line in Fig. 10. Fig. 12 is an equivalent circuit diagram (partially omitted) depicting a distributed constant transmission line formed by the variable filter element X2.

The variable filter element X2 comprises an interconnection substrate 10, signal line 21, two ground lines 22, shunt inductors 23, movable capacitor electrodes 24, drive electrodes 25 and a dielectric dot 26, and a packaging element 27 (not shown in Fig. 10), and is constructed as a resonator filter which allows passing electromagnetic waves or electric signals in a predetermined high frequency band. Substantially, the variable filter element X2 includes n number of variable filter element X1 which are disposed in a series, and comprises n stages of resonance circuit portions R which are disposed in a series via a so called "K inverter", as shown in Fig. 12. The concrete configuration of each variable filter element X1 and a concrete configuration of a unit constituting each resonance circuit portion R (interconnection substrate 10 which includes insulation layers 11 and ground line 12a, signal line 21, ground lines 22, movable capacitor electrodes 24, drive electrodes 25 and dielectric dot 26) are roughly the same as the above described first embodiment. In the present embodiment, the spatial length L2 shown in Fig. 10 is set so that the transmission line length becomes a multiple of λ/2 (λ: wavelength of extraction target, a predetermined high frequency, on the distributed constant line), for example.

In the variable filter element X2 having this configuration as well, the drive voltage to be applied between the signal line 21 and the movable capacitor electrode 24 can be easily decreased, just like the above mentioned variable filter element X1.

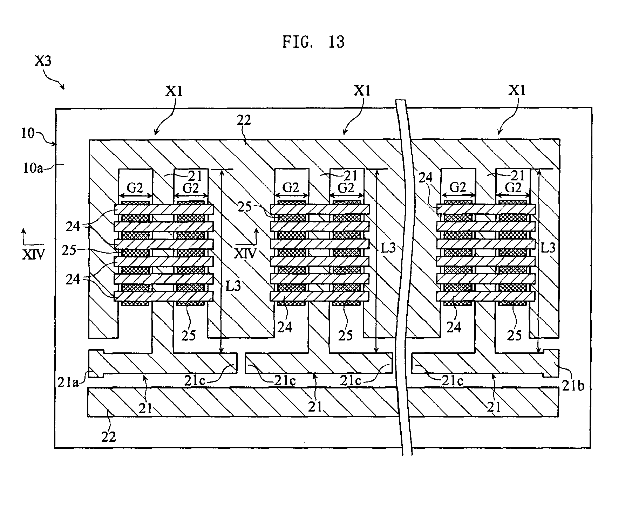

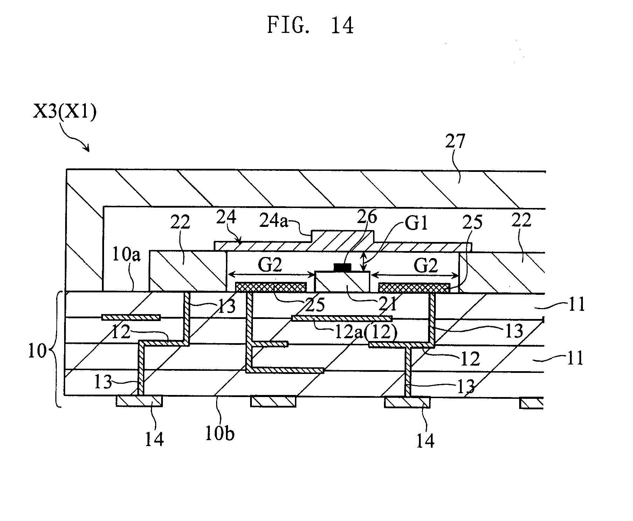

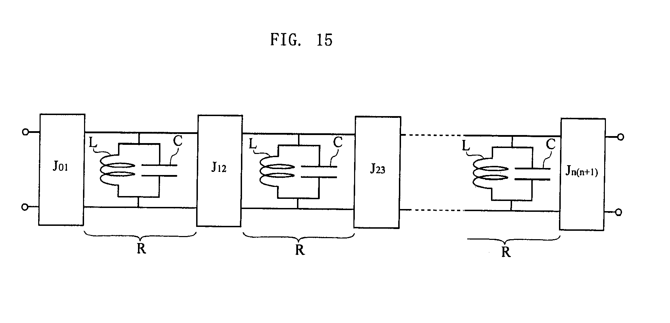

Fig. 13 to Fig. 15 show a variable filter element X3 according to the third embodiment of the present invention. Fig. 13 is a partially omitted plan view of the variable filter element X3, and Fig. 14 is an enlarged partial cross-sectional view along the XIV-XIV line in Fig. 13. Fig. 15 is an equivalent circuit diagram (partially omitted) depicting a distributed constant transmission line formed by the variable filter element X3.

The variable filter element X3 comprises an interconnection substrate 10, signal lines 21, ground lines 22, movable capacitor electrodes 24, drive electrodes 25, dielectric dot 26, and a packaging element 27 (not shown in Fig. 13), and is constructed as a resonator filter which allows passing electromagnetic waves or electric signals in a predetermined high frequency band. Substantially, the variable filter element X3 is n number of variable filter elements X1, in which shunt inductors 23 are not formed, being disposed in parallel, and comprises n stages of resonance circuit portions R which are disposed in parallel via a so called "J inverter", as shown in Fig. 15. The concrete configuration of a unit constituting each resonance circuit portion R (interconnection substrate 10 which includes insulation layers 11 and ground line 12a, signal lines 21, ground lines 22, movable capacitor electrodes 24, drive electrodes 25 and dielectric dot 26) is roughly the same as the above described first embodiment. The J inverter is a capacitor generated between the edges 21c of the signal lines 21 included in the adjacent resonance circuit portion R (capacity coupling). In the present embodiment, the spatial length L3 shown in Fig. 13 is set so that the transmission line length becomes an even numbered multiple of λ/4 (λ: wavelength of extraction target, a predetermined high frequency, on the distributed constant line).

In the variable filter element X3 having this configuration as well, the drive voltage to be applied between the signal line 21 and the movable capacitor electrodes 24 can be easily decreased, just like the above mentioned variable filter element X1.

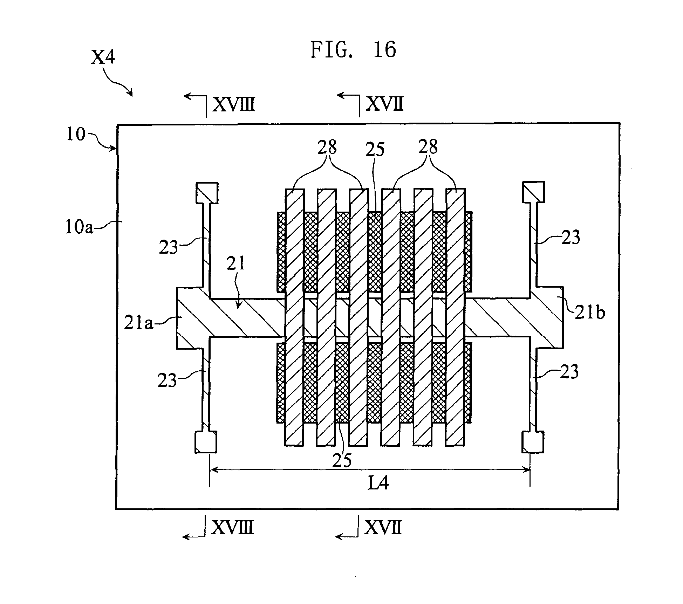

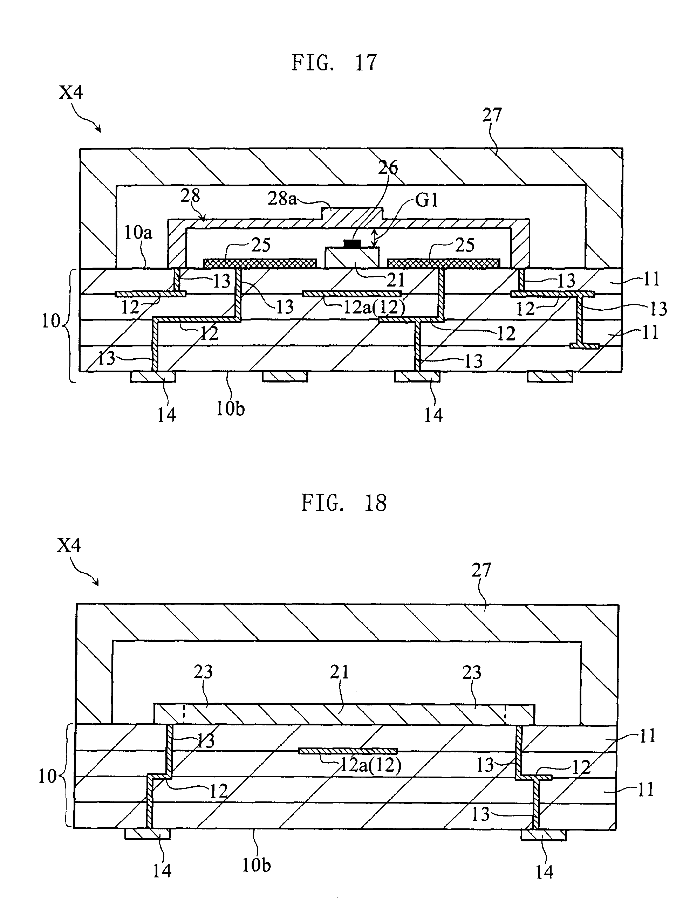

Fig. 16 to Fig. 18 show a variable filter element X4 according to the fourth embodiment of the present invention. Fig. 16 is a partially omitted plan view of the variable filter element X4. Fig. 17 and Fig. 18 are enlarged cross-sectional views along the XVII-XVII line and XVIII-XVIII line in Fig. 16. The distributed constant transmission line formed by the variable filter element X4 is represented by the equivalent circuit diagram in Fig. 4.

The variable filter element X4 comprises an interconnection substrate 10, signal line 21, four shunt inductors 23, movable capacitor electrodes 28, drive electrodes 25, a dielectric dot 26 and a packaging element 27 (not shown in Fig. 16), and is constructed as a resonator filter which allows passing electromagnetic waves or electric signals in a predetermined high frequency band. The main difference between the variable filter element X4 and the variable filter element X1 is that the variable filter element X4 has no ground line 22, and has variable capacitor electrodes 28 instead of variable capacitor electrodes 24.

As described for the first embodiment, the interconnection substrate 10 has a first face 10a and a second face 10b, and has insulation layer 11, interconnection patterns 12, vias 13 and electrode pads 14 for external connection. A part of the interconnection pattern 12 positioned closest to the first face 10a becomes a ground line 12a connected to the ground. The vias 13 connect between the interconnection patterns 12, between the interconnection pattern 12 and the electrode pad 14, and between the interconnection pattern 12 and the signal line 21.

The signal line 21 is, as described in the first embodiment, a conductive pattern having a terminal portion 21a (incoming end) and a terminal portion 21b (outgoing end) at each end where the electric signals pass between these terminal portions 21a and 21b, and includes the inductor component of this element, which is a high frequency filter. The terminal portions 21a and 21b are electrically connected to predetermined electrode pads 14 via predetermined vias 13 and interconnection patterns 12 in the interconnection substrate 10.

One end of the shunt inductor 23 is connected to the ground via predetermined vias 13, interconnection patterns 12 and electrode pad 14 in the interconnection substrate 10, as shown in Fig. 18.

Each variable capacitor electrode 28 is disposed on the interconnection substrate 10, as shown in Fig. 17, and has a thick portion 28a which faces the signal line 21, and is connected to the ground via the vias 13 and interconnection patterns 12 in the interconnection substrate 10. The movable capacitor electrodes 28 are formed of such low resistance metal as Au, Cu and Al. The mobile capacitor electrodes 28 and the signal line 21 constitute a capacity variable capacitor. The movable capacitor electrode 28 and the ground line 12a constitute the "ground interconnection portion" of the present invention.

Each drive electrode 25 generates an electrostatic attraction with the movable capacitor electrode 28, so as to displace the movable capacitor electrode 28, and is disposed adjacent to the signal line 21 and faces a part of the movable capacitor electrode 28. The drive electrodes 25 is formed of a high resistance metal thin film, such as SiCr thin film.

A dielectric dot 26 is formed on the signal line 21, as shown in Fig. 17, and is formed of such dielectric material as Al₂O₃, SiO₂, SixNy and SiOC. This dielectric dot 26 is for preventing the short circuit of the signal line 21 and the movable capacitor electrode 28, and also for increasing the electrostatic capacity of the capacitor constructed by the signal line 21 and the movable capacitor electrodes 28. Increasing the electrostatic capacity is desirable for securing a wide frequency variable area for the present element.

The packaging element 27 is for sealing various structures on the first face 10a of the interconnection substrate 10, and is bonded to the first face 10a as described in the first embodiment.

The variable filter element X4 having this structure can be represented, as shown in Fig. 4, by an equivalent circuit diagram comprised of a K₀₁ inverter, a K₁₂ inverter, and a resonance circuit portion R disposed there between. The K₀₁ inverter is comprised of a pair of shunt inductors 23, which are connected to the signal line 21 at the terminal portion 21a (incoming end) side. The K₁₂ inverter is comprised of a pair of shunt inductors 23, which are connected to the signal line 21 at the terminal portion 21b (outgoing end) side. The resonance circuit portion R includes an inductor L (inductor component in the entire resonance circuit portion R) and a capacity variable capacitor C (capacitor component in the entire resonance circuit portion R), and is mainly comprised of an interconnection substrate 10 or insulation layer 11, signal line 21, and ground interconnection portion (ground line 12a and movable capacitor electrodes 28). The capacitor C is comprised of the signal line 21 and the ground interconnection portion, and more specifically, includes the capacity variable capacitor (first capacitor) comprised of the signal line 21 and the movable capacitor electrodes 28, and the capacity fixed capacitor (second capacitor) comprised of the signal line 21 and the ground line 12a (ground line in the substrate). In other words, if it is assumed that the distributed constant transmission line formed by the variable filter element X4 has a single capacity variable capacitor C, the first capacitor comprised of the signal line 21 and the movable capacitor electrodes 28 becomes a part of this capacitor C, and in addition the second capacitor comprised of the signal line 21 and the ground line 12a also becomes a part of the capacitor C. The second capacitor has a function to compensate the contribution of the first capacitor to the electrostatic capacity of the capacitor C.

In the variable filter element X4, the spatial length L4 shown in Fig. 16 is set so that the transmission line length of the resonance circuit portion R shown in Fig. 4 (that is, transmission line length between both inverters) becomes a multiple of λ/2 (λ: wavelength of extraction target, a predetermined high frequency, on the distributed constant line). In other words, in the variable filter element X4, mixed electric signals which are input from the terminal portion 21a, for example, via predetermined electrode pads 14, vias 13 and interconnection patterns 12, are filtered, and electric signals in a predetermined high frequency band are extracted, and are output from the terminal portion 12b or predetermined electrode pad 14 connected thereto.

In the equivalent circuit diagram in Fig. 4, the resonance circuit portion R is disposed between the K₀₁ inverter and the K₁₂ inverter, and according to this configuration, electromagnetic waves or high frequency electric signals can be entered into the resonance circuit portion R from the incoming end (K₀₁ inverter side terminal) without reflection, and electromagnetic waves, which propagate to the outgoing end (K₁₂ inverter side terminal), can be emitted from this outgoing end without reflection.

In the variable filter element X4, the capacity of the capacitor C (first and second capacitors) shown in Fig. 4 can be changed by applying a predetermined voltage (drive voltage) between the drive electrodes 25 and the movable capacity electrodes 28. Applying a potential to the drive electrodes 25 can be implemented via a conductive path , which is comprised of predetermined electrode pads 14, vias 13, and interconnection patterns 12. If the drive voltage is applied between the drive electrodes 25 and the movable capacitor electrodes 28, a predetermined electrostatic attraction is generated between these electrodes, the movable capacitor electrode 28 is pulled toward the drive electrode 25 side for a predetermined amount, and as a result, the separation between the signal line 21 and the movable capacitor electrode 28 or the gap G1 decreases. If the gap G1 decreases, the electrostatic capacity of the capacitor C increases, and the entire transmission length of the variable filter element X4 increases equivalently or substantially, and the frequency band, which is allowed to pass, shifts to the lower frequency side. In this variable filter element X4, the passing frequency band can be controlled by adjusting the drive voltage to be applied. For example, the capacity of the capacitor C shown in Fig. 4 can be intentionally switched by the ON/OFF of the drive voltage, so as to switch the passing frequency band in the high frequency area appropriately (e.g. switching between 18 GHz and 22 GHz). It is also possible to continuously change the passing frequency band by analog-controlling the drive voltage.

The variable filter element X4 does not have the configuration of the signal line disposed between the two parallel ground lines on the substrate. Therefore, unlike the above mentioned conventional variable filter element X7, where the size of the gap G8 between the signal line 72 and the ground line 73 is limited to a relatively small value, the area of the drive electrodes 76 are limited to be relatively small, and the area of the drive electrodes 25 on the interconnection substrate 10 can be easily increased. Hence the variable filter element X4 can easily decrease the drive voltage to be applied between the signal line 21 and the movable capacitor electrodes 28. Decreasing the drive voltage is desirable for the compact radio communication equipment application field, such as portable telephones, of which power supplies are batteries.

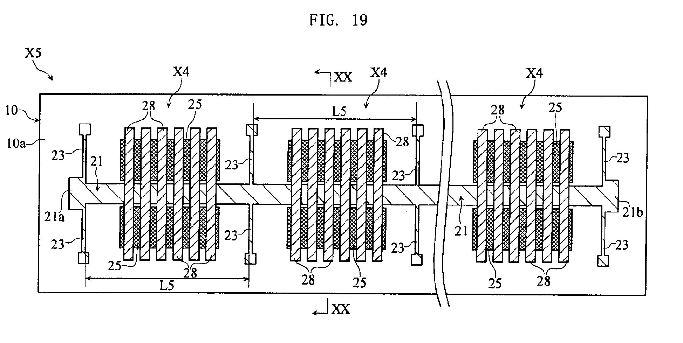

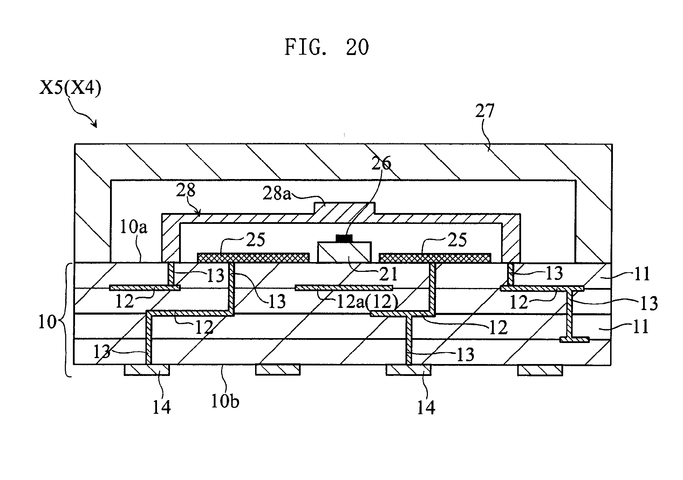

Fig. 19 and Fig. 20 show a variable filter element X5 according to the fifth embodiment of the present invention. Fig. 19 is a partially omitted plan view of the variable filter element X5, and Fig. 20 is an enlarged cross-sectional view along the XX-XX line in Fig. 19. Fig. 12 is an equivalent circuit diagram (partially omitted) depicting a distributed constant transmission line formed by the variable filter element X5.

The variable filter element X5 comprises an interconnection substrate 10, signal line 21, shunt inductors 23, variable capacitor electrodes 28, drive electrodes 25, a dielectric dot 26 and a packaging element 27 (not shown in Fig. 19), and is constructed as a resonator filter which allows passing electromagnetic waves or electric signals in a predetermined high frequency band. Substantially the variable filter element X5 includes n number of variable filter elements X4 which are disposed in a series, and comprises n stages of resonance circuit portions R which are disposed in series via a so called "K inverter", as shown in Fig. 12. The concrete configuration of each variable filter element X4 and a concrete configuration of a unit constituting each resonance circuit portion R (interconnection substrate 10 which includes insulation layers 11 and ground line 12a, signal line 21, movable capacitor electrodes 28, drive electrodes 25 and dielectric dot 26) are roughly the same as the above described first or fourth embodiment. In the present embodiment, the spatial length L5 shown in Fig. 19 is set so that the transmission line length becomes a multiple of λ/2 (λ: wavelength of extraction target, a predetermined high frequency, on the distributed constant line), for example.

In the variable filter element X5 having this configuration as well, the drive voltage to be applied between the signal line 21 and the movable capacitor electrode 28 can be easily decreased, just like the above mentioned variable filter element X4.

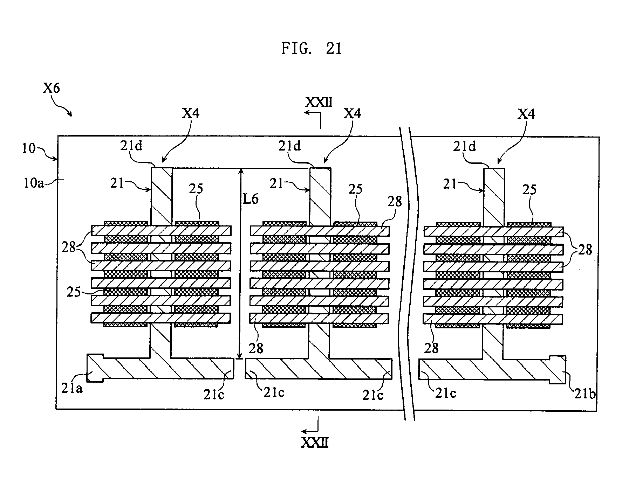

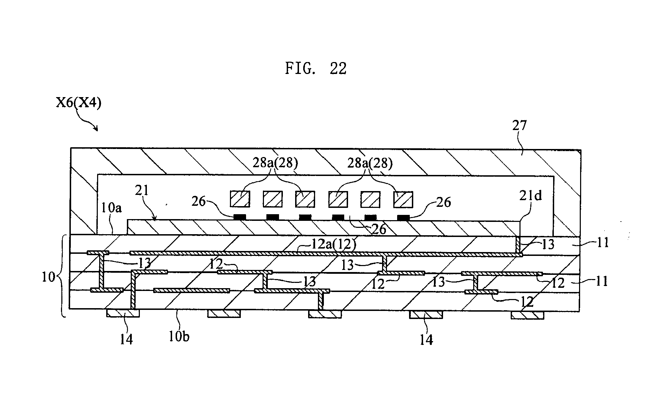

Fig. 21 and Fig. 22 show a variable filter element X6 according to the sixth embodiment of the present invention. Fig. 21 is a partially omitted plan view of the variable filter element X6, and Fig. 22 is an enlarged cross-sectional view along the XXII-XXII line in Fig. 21. The distributed constant transmission line formed by the variable filter element X6 is shown in the equivalent circuit diagram (partially omitted) shown in Fig. 15.

The variable filter element X6 comprises an interconnection substrate 10, signal lines 21, movable capacitor electrodes 28, drive electrodes 25, a dielectric dot 26 and packaging element 27 (not shown in Fig. 21), and is constructed as a resonator filter which allows passing electromagnetic waves or electric signals in a predetermined high frequency band. Substantially, the variable filter element X6 is n number of variable filter elements X4 in which shunt indicators 23 are not formed, being disposed in parallel, and comprises n stages of resonance circuit portions R which are disposed in parallel via a so called "J inverter", as shown in Fig. 15. The concrete configuration of a unit constituting each resonance circuit portion R (interconnection substrate 10 which includes insulation layers 11, ground line 12a, signal lines 21, movable capacitor electrodes 28, drive electrodes 25 and dielectric dot 26) is roughly the same as the above described first or fourth embodiments. The J inverter is a capacitor generated between the edges 21c of the signal lines 21 included in the adjacent resonance circuit portions R (capacity coupling). In the present embodiment, the edge 21d of the signal line 21 of each resonance circuit portion R is electrically connected to the ground line 12a via the via 13, and therefore is connected to the ground, as shown in Fig. 21 and Fig. 22. The signal line 21 may be designed to be electrically open, instead of being connected to the ground like this. (Concretely, the vias 13 for connecting the signal line 21 and the ground line 12a are not formed.) In the present embodiment, the spatial length L6 shown in Fig. 21 is set so that the transmission line length becomes an even number multiple of λ/4 (λ: wavelength of extraction target, a predetermined high frequency, on the distributed constant line).

In the variable filter element X6 having this configuration as well, the drive voltage to be applied between the signal line 21 and the movable capacitor electrodes 28 can be easily decreased, just like the above mentioned variable filter element X4.

To summarize this, a configuration of the present invention and variant forms thereof will be listed below as Appendixes.

### (Appendix 1)

A variable filter element, comprising: a substrate; two ground lines on the substrate and a signal line between the ground lines on the substrate, which are disposed to extend in parallel on the substrate; movable capacitor electrodes which bridge between the two ground lines on the substrate and have portions facing the signal line; drive electrodes which are located between the signal line and the ground lines on the substrate and generate electrostatic attraction with the movable capacitor electrodes; and a ground line, in the substrate, which is disposed in the substrate, has a portion facing the signal line, and is electrically connected with the two ground lines on the substrate, wherein the ground line on the substrate, the movable capacitor electrodes and the ground line in the substrate constitute a ground interconnection portion, and the signal line and the ground interconnection portion constitute a distributed constant transmission line.

### (Appendix 2)

A variable filter element, comprising: a substrate; signal lines disposed to extend in parallel on the substrate; movable capacitor electrodes which protrudes on the substrate and have positions facing the signal lines; drive electrodes which are formed on the substrate and generate electrostatic attraction with the movable capacitor electrodes; and a ground line, in the substrate, which is formed in the substrate, has portions facing the signal lines and is electrically connected with the movable capacitor electrodes, wherein the movable capacitor electrodes and the ground lines in the substrate constitute a ground interconnection portion, and the signal lines and the ground interconnection portions constitute a distributed constant transmission line.

### (Appendix 3)

The variable filter element according to Appendix 2, further comprising a ground line on the substrate which is disposed in parallel with the signal lines on the substrate, and is electrically connected with the ground line in the substrate.

### (Appendix 4)

The variable filter element according to any one of Appendixes 1 to 3, further comprising a dielectric portion on the signal line.

### (Appendix 5)

The variable filter element according to any one of Appendixes 1 to 4, wherein the substrate is a multilayer interconnection substrate which has a layered structure comprising a plurality of insulation layers and interconnection pattern between each insulation layer.

### (Appendix 6)

The variable filter element according to Appendix 5, wherein the ground line in the substrate is included in an interconnection pattern closest to the signal line on the multilayer interconnection substrate.

### (Appendix 7)

The variable filter element according to Appendix 5 or 6, wherein the insulation layer is made of ceramic.

### (Appendix 8)

The variable filter element according to any one of Appendixes 5 to 7, further comprising electrode pads on an opposite surface from the signal line on the substrate.

### (Appendix 9)

The variable filter element according to any one of Appendixes 5 to 8, further comprising a conductive connection portion which penetrates through the substrate.

### (Appendix 10)

A variable filter element comprising a plurality of variable filter elements according to any of Appendixes 1 to 9, wherein the plurality of variable filter elements are disposed in series or in parallel.

### (Appendix 11)

A variable filter module comprising the variable filter element according to any of Appendixes 1 to 10, and a plurality of passive elements disposed on the substrate.

### (Appendix 12)

The variable filter module according to Appendix 11, wherein the plurality of passive elements include an inductor, capacitor or resistor.

### (Appendix 13)

A variable filter element fabrication method for fabricating the variable filter element according to any one of Appendixes 1 to 10, comprising the steps of: fabricating an interconnection substrate wafer which has a plurality of variable filter element formation blocks each of which includes a ground line in the substrate; forming at least a signal line, drive electrodes and variable capacitor electrodes on the interconnection substrate wafer in each of the plurality of variable filter element formation blocks; and separating the interconnection substrate wafer.

### (Appendix 14)

A variable filter module fabrication method for fabricating the variable filter module according to Appendix 11 or 12, comprising the steps of: fabricating an interconnection substrate wafer which has a plurality of variable filter module formation blocks each of which includes a ground line in the substrate; forming at least a signal line, drive electrodes and variable capacitor electrodes and a plurality of passive element groups on the interconnection substrate wafer in each of the plurality of variable filter module formation blocks; and separating the interconnection substrate wafer.

### (Appendix 15)

The method according to Appendix 13 or 14, further comprising a step of mounting a sealing cap for each of the formation blocks, before the separation step.

## Claims

1. A variable filter element (X1), comprising:
a substrate (10);
two ground lines (22) on the substrate (10) and a signal line (21) between the ground lines (22) on the substrate (10), which are disposed to extend in parallel on the substrate (10);
movable capacitor electrodes (24) which bridge between the two ground lines (22) on the substrate (10) and have portions facing the signal line (21); and
drive electrodes (25) which are located between the signal line (21) and the ground lines (22) on the substrate (10) and generate electrostatic attraction with the movable capacitor electrodes (24); **characterized by** comprising
a ground line (12a), in the substrate (10), which is disposed in the substrate (10), has a portion facing the signal line (21), and is electrically connected with the two ground lines (22) on the substrate (10);
wherein the ground lines (22) on the substrate (10), the movable capacitor electrodes (24) and the ground line (12a) in the substrate (10) constitute a ground interconnection portion,
wherein the signal line (21) and the ground interconnection portion constitute a distributed constant transmission line.

2. The variable filter element (X1) according to claim 1, further comprising a dielectric portion (26) on the signal line (21).

3. The variable filter element (X1) according to claim 1, wherein the substrate (10) is a multilayer interconnection substrate which has a layered structure comprising a plurality of insulation layers (11) and interconnection pattern (12) between each insulation layer (11).

4. A variable filter element (X2) comprising a plurality of variable filter elements (X1) according to claim 1, wherein the plurality of variable filter elements (X1) are disposed in series or in parallel.

5. A variable filter module comprising: a variable filter element (X1) according to claim 1; and a plurality of passive elements provided on the substrate (10).

6. A variable filter element fabrication method for fabricating a variable filter element according to claim 1, the method comprising the steps of:
fabricating an interconnection substrate wafer which has a plurality of variable filter element formation blocks each of which includes a ground line in the substrate;
forming at least a signal line, drive electrodes and variable capacitor electrodes on the interconnection substrate wafer, in each of the plurality of variable filter element formation blocks; and
separating the interconnection substrate wafer.

7. A variable filter modulate fabrication method for fabricating a variable filter module according to claim 5, the method comprising the steps of:
fabricating an interconnection substrate wafer which has a plurality of variable filter module formation blocks each of which includes a ground line in the substrate;
forming at least a signal line, drive electrodes and variable capacitor electrodes and a plurality of passive element groups on the interconnection substrate wafer in each of the plurality of variable filter module formation blocks; and
separating the interconnection substrate wafer.
